# EUROPÄISCHE PATENTSCHRIFT

(11) **EP 1 176 606 B1**
(45) Veröffentlichungstag und Bekanntmachung des Hinweises auf die Patenterteilung: **03.03.2010**
(21) Anmeldenummer: 01115502.5
(22) Anmeldetag: 27.06.2001
(51) Int. Cl.: G11C 29/00

(54) **Verfahren und Vorrichtung zum Einlesen und zur Überprüfung der zeitlichen Lage von aus einem zu testenden Speicherbaustein ausgelesenen Datenantwortsignalen**
Method and device for establishing and testing the response signal timing of a memory under test
Procédé et dispositif pour établir et tester le comportement temporel d'un signal de réponse d'une mémoire sous test

(30) Priorität: 18.07.2000 DE 10034852
(43) Veröffentlichungstag der Anmeldung: 30.01.2002
(73) Patentinhaber: Qimonda AG, 81739 München (DE)
(72) Erfinder: Ernst, Wolfgang, 81541 München (DE); Krause, Gunnar, 81541 München (DE); Kuhn, Justus, 81373 München (DE); Luepke, Jens, 81829 München (DE); Mueller, Jochen, 81825 München (DE); Poechmueller, Peter, 81739 München (DE); Schittenhelm, Michael, 85586 Poing (DE)
(74) Vertreter: Müller - Hoffmann & Partner

(56) Entgegenhaltungen:
- DE-A1- 19 855 488
- US-A- 4 849 973
- PATENT ABSTRACTS OF JAPAN Bd. 2000, Nr. 06, 22. September 2000 (2000-09-22) & JP 2000 076853 A (MITSUBISHI ELECTRIC CORP), 14. März 2000 (2000-03-14) & US 6 324 118 B1 (OOISHI TSUKASA) 27. November 2001 (2001-11-27)

## Beschreibung

Die Erfindung betrifft ein Verfahren und eine Vorrichtung zum Einlesen einer beim Test aus einem zu testenden Speicherbaustein, insbesondere aus einem DRAM-Speicher im DDR-Betrieb ausgelesenen Datenantwort in einem Testempfänger.

Heutige dynamische Halbleiterspeicher mit wahlfreiem Zugriff (DRAM-Speicher) werden nach ihrer Herstellung mit Hilfe kostspieliger Produktionstestsysteme getestet. Diese erlauben es, Signale mit genau definierten Spannungspegeln zu exakt definierten Zeitpunkten an den zu testenden DRAM-Speicher (DUT = Device Under Test) anzulegen. Zur Überprüfung der Lesefunktion des zu testenden DRAM-Speichers werden von diesem ausgelesene Signale zu genau definierten Zeitpunkten in das Testsystem eingelesen und mit erwarteten Signalwerten verglichen.

Aufgrund der hohen Arbeitsfrequenzen heutiger Speicherbausteine (bis zu 400 MHz Taktfrequenz, z.B. bei Rambus-DRAMs) erfordert die Spezifikation der Lese- und Schreibsignale solcher Speicherbausteine eine sehr hohe Genauigkeit, zum Beispiel sind bei Double Data Rate oder DDR-DRAM-Speichern (heute sind bereits Signalspezifikationen in der Größenordnung von 500 ps üblich). Aus diesem Grunde müssen die dafür geeigneten Produktionstestsysteme höchsten technischen Anforderungen genügen, was zu entsprechend hohen Kosten führt. Aus diesem Grund betragen die Testkosten von höchstfrequenten Speicherbausteinen bereits bis zu 30 % ihrer Gesamtherstellungskosten.

Besonders kritisch gestaltet sich heute die Messung des sogenannten Datenstrobe-Antwortsignals DQS beim Lesevorgang von einem im DDR-Betrieb arbeitenden DRAM-Speicher. Bei im DDR-Betrieb arbeitenden DRAM- und anderen Speichern wird ein sogenanntes Datenstrobe-Antwortsignal oder DQS gesendet, aufgrund dessen das Einlesen der DQ-Information durch einen Controller, der in diesem Fall das Testsystem ist, bei höchsten Frequenzen erfolgt. Bei diesem Datenstrobe-Antwort- oder DQS-Signal handelt es sich um ein alternierendes Signal, das der Empfänger, in diesem Fall der Testempfänger dazu benutzt, um mit jeder steigenden und fallenden Flanke des DQS-Signals die Datenantwort, d.h. das DQ-Signal, einzulesen.

Nach dem oben Gesagten, sollte beim Test das Datenstrobe-Antwortsignal DQS wie beim echten Betrieb mit einem Controller durch das Testsystem dazu verwendet werden, die Datenantwortsignale direkt in Abhängigkeit von dem Datenstrobe-Antwortsignal einzulesen. Allerdings weisen heutige Produktionstestsysteme diese Funktion nicht auf. Dagegen wird bei heutigen, in der Produktion eingesetzten, Speichertestsystemen das Datenstrobe-Antwortsignal wie jedes Datenantwortsignal oder DQ-Signal betrachtet und im Testsystem relativ zu einer internen Zeitreferenz verglichen. Dadurch ist ein direkter Vergleich des Datenstrobe-Antwortsignals DQS mit den Datenantwortsignalen DQ nicht möglich. Statt dessen wird bei heutigen Testsystemen das Datenstrobe-Antwortsignal DQS gegenüber einer internen Zeitreferenz verglichen und danach die Datenantwortsignale DQ. Schließlich kann aus der gemessenen Differenz auf die Abweichung des Datenstrobe-Antwortsignals DQS gegenüber den Datenantwortsignalen DQ geschlossen werden.

Ein Hauptnachteil dieser Vorgehensweise liegt in der erhöhten Testzeit, da ja sequentiell vorgegangen wird, und in einer größeren Ungenauigkeit des Meßergebnisses.

Es ist Aufgabe der Erfindung, ein Verfahren und eine Vorrichtung zum Einlesen und zur Überprüfung der zeitlichen Lage einer beim Test aus einem zu testenden Speicherbaustein, insbesondere aus einem im DDR-Betrieb arbeitenden DRAM-Speicher ausgelesenen Datenantwort in einen Testempfänger so zu ermöglichen, dass die Testzeit verkürzt und die Meßgenauigkeit erhöht werden kann.

Zur Lösung dieser Aufgabe schlägt das erfindungsgemäße Verfahren vor, daß das Einlesen der Datenantwort im Testempfänger zeitlich von einem Strobesignal gesteuert wird, das intern im Testempfänger aus dem vom zu testenden Speicherbaustein ausgegebenen und vom Testempfänger empfangenen Datenstrobe-Antwortsignal direkt erzeugt wird und daß die Überprüfung der zeitlichen Lage der Datenantwort durch deren Vergleich mit dem im Testempfänger erzeugten Strobesignal erfolgt.

Dabei wird das Strobesignal durch eine Zeitverzögerung des empfangenen Datenstrobe-Antwortsignals erzeugt, welche Sollwerten der zeitlichen Lage der vom zu testenden Speicherbaustin ausgelesenen Datenantwort bezogen auf das vom selben Speicherbaustein erzeugte Datenstrobe-Antwortsignal entspricht.

Bevorzugt ist eine programmierbar einstellbare Verzögerungszeit einer Verzögerungseinrichtung im Testempfänger vorgesehen. Dabei wird zur Ermittlung der in die Verzögerungseinrichtung einzuprogrammierenden Verzögerungszeit im Testempfänger jeweils ein Kalibriersignal für die Datenantwort und das Datenstrobe-Antwortsignal erzeugt und mit diesen Kalibriersignalen die entsprechenden Testsignaleingänge des Testempfängers beaufschlagt.

Alternativ können die Kalibriersignale oder das Kalibriersignal auch extern erzeugt und dem Testempfänger zugeführt werden.

Dabei sind die Kalibriersignale für die Datenantwort und das Datenstrobe-Antwortsignal ein einziges Taktsignal, dessen Frequenz bevorzugt mit der Frequenz des vom zu testenden Speicherbaustein erzeugten Datenstrobe-Antwortsignals übereinstimmt.

In weiteren parallelen Patentanmeldungen schlagen die Erfinder vor, Testfunktionen für zu testende Speicherbausteine, an die hohe zeitliche Anforderungen gestellt werden, in einer von einem üblichen Halbleiterspeichertestsystem separaten Halbleiterschaltung in Form einer möglichst einfachen ASIC-Schaltung zu realisieren, die aufgrund verhältnismäßig geringer Herstellungskosten und kleinen Abmessungen in unmittelbarer Nähe des zu testenden Halbleiterspeicherbausteins vorgesehen ist. Hierdurch kann die Genauigkeit und die Frequenz des Tests erhöht werden, da durch die kurzen Leitungen Signallaufzeiten bzw. Laufzeitunterschiede zwischen verschiedenen Signalen reduziert werden können. Diese Lösung eines vom üblichen Halbleiterspeichertestsystem abgesetzten separaten BOST-Bausteins (BOST = Build Outside Self Test) ermöglicht für den hier beschriebenen Fall die Einhaltung der für einen genauen Test der zeitlichen Beziehungen zwischen den DQ-Signalen und dem Datenstrobe-Antwortsignal DQS vom zu testenden Speicherbaustein einzuhaltende Randbedingung einer konstanten und kurzen Laufzeit zwischen dem zu testenden Speicherbaustein und dem Testsystem, in diesem Fall dem BOST-Baustein.

Darüber hinaus schlägt das erfindungsgemäße Verfahren in dem BOST-Schaltkreis eine programmierbare Kalibrierung des Datenstrobe-Antwortsignals DQS vor, welche einen zeitlich hochgenauen und kostengünstigen Test unterstützt.

Dies gilt insbesondere für mit hohen Frequenzen arbeitende DRAM-Speicherbausteine, die im DDR-Betrieb (Double Data Rate) getestet werden. Durch den direkten Vergleich der Datenantwort mit der vom Datenstrobe-Antwortsignal DQS gebildeten Zeitreferenz im Testempfänger, d.h. im BOST-Baustein, wird deshalb ein applikationsnaher Mechanismus zum Einlesen der DQ-Daten bereitgestellt.

Nachstehend folgt eine Beschreibung der Struktur und der Funktionalität des erfindungsgemäßen Verfahrens anhand eines eine BOST-Lösung bildenden, in der Zeichnung dargestellten, Ausführungsbeispiels.

Die Zeichnungsfiguren zeigen:
- Fig. 1: ein Blockschaltbild eines durch eine BOST-Lösung realisierten Ausführungsbeispiels einer erfin- dungsgemäßen Vorrichtung mit Mitteln zum Kali- brieren des DQS-Signals und
- Fig. 2: Signalzeitdiagramme von Signalen A-F an einzelnen Signalleitungen der in Fig. 1 dargestellten Schaltung.

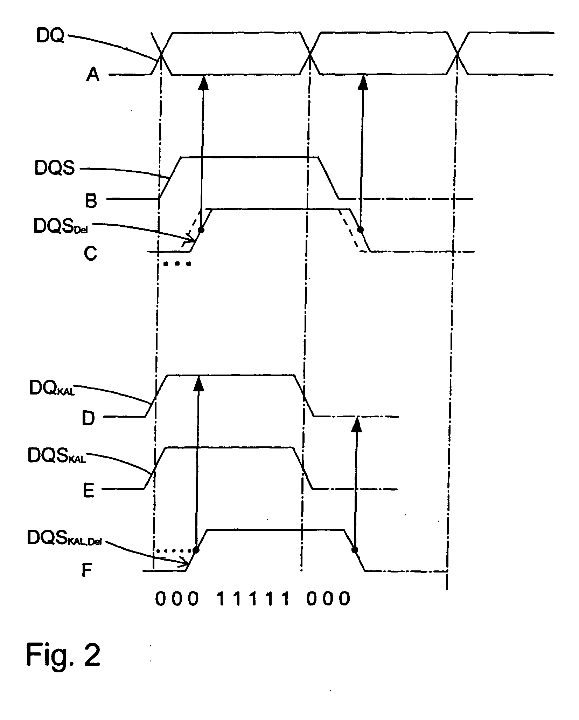

In der bevorzugt vorgeschlagenen BOST-Lösung der erfindungsgemäßen Vorrichtung zum Einlesen und zur Überprüfung der zeitlichen Lage einer beim Test aus einem zu testenden Speicherbaustein DUT insbesondere einem DRAM-Speicher im DDR-Betrieb ausgelesenen Datenantwort wird diese Datenantwort DQ, die am Eingangsanschluß A empfangen wird, mit einem Strobesignal DQS_{DEL} (C in Fig. 2) eingelesen, d. h. zwischengespeichert, das durch Zeitverzögerung des vom zu testenden Speicherbaustein DUT erzeugten und am Eingangsanschluß B empfangenen Datenstrobe-Antwortsignal DQS erzeugt wird.

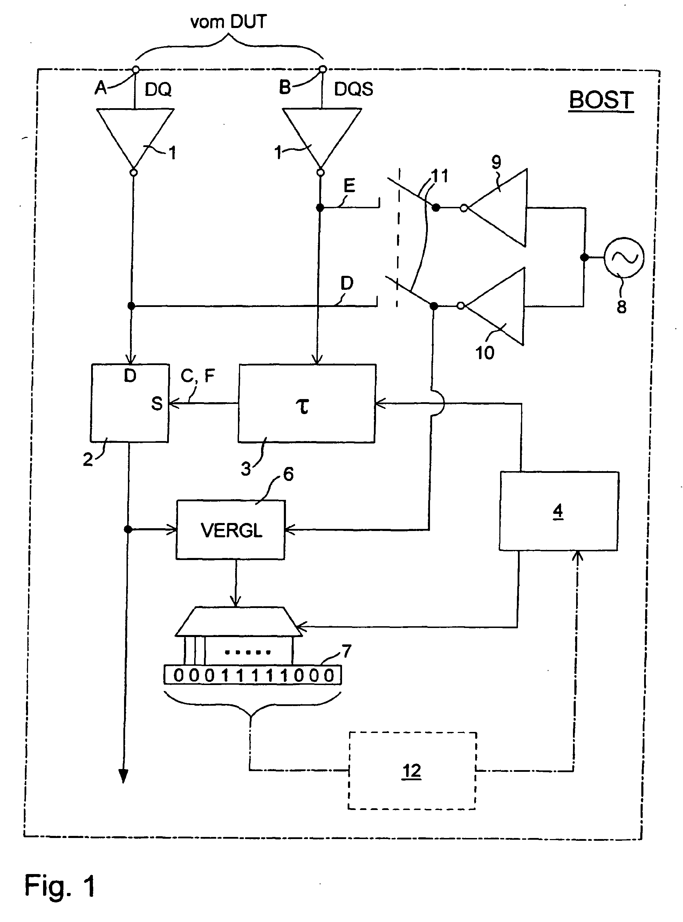

Es ist zu bemerken, daß zur Vereinfachung der Beschreibung in der Fig. 1 nur ein einziges DQ-Signal am Anschluß A dargestellt ist.

Das am Anschluß A vom DUT ankommende Datenantwortsignal DQ gelangt über einen Bufferschaltkreis, zum Beispiel einen Tristatebuffer 1 zu einem Dateneingang D eines Datenlatches 2. Das am Dateneingang D anliegende Signal DQ (A in Fig. 2) wird in das Datenlatch 2 mit einem an seinem Setzeingang S anliegenden Signal C eingelatcht, welches aus dem Datenstrobe-Antwortsignal DQS (Signal am Eingang B) durch Verzögerung um eine bestimmte Verzögerungszeit T in einer Verzögerungseinrichtung 3 erzeugt wird.

Hier ist zu bemerken, daß die Spezifikation für im Data-Double-Rate- oder DDR-Betrieb arbeitenden DRAM-Speicher eine sehr genaue Zeitbeziehung zwischen dem Datenantwortsignal DQ und dem Datenstrobe-Antwortsignal DQS vorsieht. Für solche im DDR-Betrieb arbeitende DRAM-Speicher ist beispielsweise festgelegt, daß DQ und DQS maximal um ± 500 ps voneinander abweichen dürfen, um ein sicheres Lesen beim Empfänger, zum Beispiel einem Controller, zu gewährleisten.

Unter Berücksichtigung dieser hochgenauen Spezifikation muß das das erfindungsgemäße Verfahren und die erfindungsgemäße Vorrichtung benutzende Testsystem, bei dem der BOST-Baustein ganz in der Nähe des zu testenden Speicherbausteins angeordnet ist, die Randbedingung erfüllen, daß die Laufzeit der Datenantwort DQ und des Datenstrobe-Antwortsignals DQS über die Schnittstellen und die Leitungen für ein und denselben BOST-Baustein bzw. für ein und dasselbe Testsystem immer konstant ist.

Unter Einhaltung dieser Randbedingung schafft die in die Verzögerungseinrichtung 3 gezielt einprogrammierte Verzögerungszeit τ eine Sollbedingung zur Überprüfung der zeitlichen Lage zwischen der vom DUT einzulesenden Datenantwort DQ und dem Datenstrobe-Antwortsignal DQS. Ein Mißerfolg beim Einlesen der Datenantwort DQ in das Latch 2 ist nämlich, wenn eine optimale oder Sollzeitverzögerung T in der Verzögerungseinrichtung 3 eingestellt wurde ein Kriterium dafür, daß die zeitliche Beziehung zwischen der vom DUT empfangenen Datenantwort DQ und dem Datenstrobe-Antwortsignal DQS beim Test nicht korrekt ist.

Nun folgt eine Beschreibung der Funktion der in der Schaltung gemäß Fig. 1 realisierten Kalibriereinrichtung. Um ein möglichst präzises, temperaturunabhängiges Einlesen der Datenantwort DQ in das Latch 2 zu ermöglichen, wird die Verzögerungszeit τ, mit der das Datenstrobe-Antwortsignal DQS in der Verzögerungseinrichtung 3 verzögert wird, wie folgt kalibriert. Die Schaltungsanordnung weist einen Kalibriersignalgenerator 8 und Treiber 9 und 10 sowie eine Schalteranordnung 11 auf, mit der in einem Kalibrierzyklus bevorzugt ein symmetrisches Taktsignal erzeugt und zugeführt wird, welches ausgangsseitig der Pufferverstärker 9 und 10 in die identischen Kalibriersignale DQ_{KAL} (Fig. 2: D) und DQS_{KAL} (Fig. 2: E) verzweigt wird. Die Verzögerungseinrichtung 3 ist über einen Zähler 4 programmierbar. Ein Vergleicher 6 vergleicht, ob das Datenlatch 2 das Kalibriersignal DQ_{KAL} (D) mit dem um die Verzögerungszeit T in der Verzögerungseinrichtung 3 verzögerten Kalibriersignal DQS_{KAL,DEL} (Fig. 2: F) korrekt eingelesen hat oder nicht. Das Ergebnis des Vergleichers 6 wird in ein Register 7 eingespeichert. Zur Kalibrierung der Verzögerungszeit τ wird der Zähler 4 linear hochgezählt und das Vergleichsergebnis schrittweise im Register 7 abgespeichert.

Die in Fig. 1 angedeuteten Registerinhalte zeigen beispielhaft, daß eine "0" im Register 7 abgelegt wird, wenn das Vergleichsergebnis des Vergleichers 6 negativ ist und daß eine "1" abgelegt wird, wenn das Vergleichsergebnis des Vergleichers 6 positiv ist. Im veranschaulichend dargestellten Beispiel werden die Daten für die Zählerpositionen 3 bis 7 korrekt eingelesen. Dieses Ergebnis des Kalibriervorgangs bedeutet, daß in diesem Bereich vom Zählerstand 3 bis 7 das Datenauge ausreichend gut getroffen wird, d.h. daß die Flanke des um die Verzögerungszeit τ in der Verzögerungseinrichtung 3 verzögerten Kalibriersignals DQS_{KAL,DEL} (F) den jeweiligen logischen Wert des Kalibriersignals DQ_{KAL} (D) für die Datenantwort richtig in das Latch 2 eingelatcht hat.

Fig. 1 enthält gestrichelt eingezeichnet eine Auswerteeinrichtung 12, die das im Register 7 stehende Kalibrierergebnis auswertet und entsprechend dem Auswerteergebnis den Zähler 4 auf einen mittigen Wert, in diesem Beispiel auf den Zählerstand "5" für den dem Kalibriervorgang folgenden echten Testbetrieb einstellt.

Wenn die Frequenz des Kalibriersignals 8 bekannt ist und wenn die oben angeführte Randbedingung eingehalten ist, kann das Verfahren und die Vorrichtung auch zum Testen der zeitlichen Verhältnisse zwischen dem echten Datenstrobe-Antwortsignal DQS und der Datenantwort DQ verwendet werden. Nehmen wir zum Beispiel an, daß das Kalibriersignal in Fig. 1 500 MHz beträgt. 500 MHz entsprechen einer Zykluszeit von 2 ns, d.h. daß das Kalibriersignal 1 ns hohen Pegel und 1 ns tiefen Pegel hat. Da im Kalibrierzyklus im Register 7 das Kalibriersignal DQ_{KAL} für die Datenantwort über fünf Zählerpositionen korrekt eingelesen wurde, entspricht eine Zählerposition einer Verzögerung von 200 ps. Somit läßt sich der Inhalt des Registers 7 auf die zeitliche Beziehung zwischen der Datenantwort DQ und dem Datenstrobe-Antwortsignal DQS auswerten.

Es ist zu erwähnen, daß die in Fig. 1 dargestellte Schaltungsanordnung der Vorrichtung zum Einlesen und zur Überprüfung der zeitlichen Lage einer beim Test aus einem zu testenden Speicherbaustein, insbesondere einem DRAM im DDR-Betrieb, ausgelesenen Datenantwort mit Hilfe des um eine bestimmte Verzögerungszeit verzögerten echten Datenantwortsignals lediglich eine beispielshafte Prinzipausführung darstellt. Zahlreiche schaltungstechnische Realisierungen dieses Prinzips sind möglich, zum Beispiel könnten in einer konkreten Realisierung die Bufferverstärker 1, das Datenlatch 2 und die Verzögerungseinrichtung 3 in einer einzigen Schaltungseinheit realisiert werden. Zum Einlatchen der Datenantwort DQ können auch zwei Datenlatches 2 vorgesehen sein, so daß jeweils mit der steigenden und fallenden Flanke des am Setzeingang der Datenlatches 2 anliegenden verzögerten Datenstrobe-Antwortsignals DQS eingelatcht wird.

## Patentansprüche

1. Verfahren zum Einlesen und zur Überprüfung der zeitlichen Lage einer beim Test aus einem zu testenden schnellen Speicherbaustein, insbesondere DRAM-Speicher im DDR-Betrieb ausgelesenen Datenantwort (DQ) in einem Testempfänger (BOST),
**dadurch gekennzeichnet, dass**
das Einlesen der Datenantwort (DQ) zeitlich von einem Strobesignal (DQS_{DEL}) gesteuert wird, das aus einem vom zu testenden Speicherbaustein (DUT) ausgegebenen und vom Testempfänger (BOST) empfangenen Datenstrobe-Antwortsignal (DQS) im Testempfänger (BOST) erzeugt wird, wobei die Überprüfung der zeitlichen Lage der Datenantwort (DQ) durch deren Vergleich mit dem im Testempfänger (BOST) erzeugten Strobesignal (DQS_{DEL}) erfolgt.

2. Verfahren nach Anspruch 1,
**dadurch gekennzeichnet, daß**
das Strobesignal (DQS_{DEL}) durch Zeitverzögerung um eine bestimmte Verzögerungszeit (τ) des im Testempfänger (BOST) empfangenen Datenstrobe-Antwortsignals (DQS) erzeugt wird, wobei die Verzögerungszeit (τ) entsprechend Sollwerten der zeitlichen Lage der vom zu testenden Speicherbaustein (DUT) ausgelesenen Datenantwort (DQ) und des Datenstrobe-Antwortsignals (DQS) ermittelt und eingestellt wird.

3. Verfahren nach Anspruch 2,
**dadurch gekennzeichnet, daß**
die eingestellte Verzögerungszeit (τ) in eine programmierbare Verzögerungseinrichtung (3) des Testempfängers (BOST) einprogrammiert wird.

4. Verfahren nach Anspruch 2 oder 3,
**dadurch gekennzeichnet, daß**
zur Ermittlung der Verzögerungszeit (τ) (BOST) ein Kalibriersignal (DQ_{KAL}, DQS_{KAL}) für die Datenantwort (DQ) und das Datenstrobe-Antwortsignal (DQS) im Testempfänger erzeugt und den Testsignaleingängen (A, B) für die Datenantwort (DQ) und das Datenstrobe-Antwortsignal (DQS) zugeführt wird.

5. Verfahren nach einem der Ansprüche 2 oder 3,
**dadurch gekennzeichnet, daß**
zur Ermittlung der in die Verzögerungseinrichtung (3) einzuprogrammierenden Verzögerungszeit (τ) die Testsignaleingänge (A, B) des Testempfängers (BOST) für die Datenantwort (DQ) und das Datenstrobe-Antwortsignal (DQS) mit einem extern erzeugten Kalibriersignal (DQ_{KAL}, DQS_{KAL}) beaufschlagt werden.

6. Verfahren nach Anspruch 4 oder 5,
**dadurch gekennzeichnetet, daß**
die Kalibriersignale (DQ_{KAL}, DQS_{KAL}) für die Datenantwort (DQ) und das Datenstrobe-Antwortsignal (DQS) identische Taktsignale sind.

7. Verfahren nach Anspruch 6,
**dadurch gekennzeichnet, daß**
die Kalibriersignale (DQ_{KAL}, DQS_{KAL}) als ein symmetrisches Taktsignal mit einer mit der Frequenz der Datenantwort (DQ) und des Datenstrobe-Antwortsignals (DQS) vom zu testenden Speicherbaustein (DUT) übereinstimmenden Frequenz erzeugt werden.

8. Verfahren nach einem der vorangehenden Ansprüche,
**dadurch gekennzeichnet, daß**
die vom zu testenden Speicherbaustein einzulesende Datenantwort (DQ) eine Datenantwortsignalgruppe ist, deren Einzelsignale jeweils gleiche zeitliche Sollbeziehung zum vom zu testenden Speicherbaustein erzeugten Datenstrobe-Antwortsignal (DQS) aufweisen.

9. Verfahren nach einem der vorangehenden Ansprüche,
**dadurch gekennzeichnet, daß**
die ermittelte und in die Verzögerungseinrichtung (3) einzuprogrammierende Verzögerungszeit (τ) als Test-Vergleichswert für die zeitliche Beziehung zwischen der Datenantwort (DQ) und dem Datenstrobe-Antwortsignal (DQS) gespeichert und zum Test dieser zeitlichen Beziehung verwendet wird.

10. Vorrichtung zum Einlesen und zur Überprüfung der zeitlichen Lage einer beim Test aus einem zu testenden Speicherbaustein (DUT), insbesondere aus einem DRAM-Speicher im DDR-Betrieb ausgelesenen Datenantwort (DQ) in einem Testempfänger (BOST), insbesondere zur Durchführung des Verfahrens nach einem der Ansprüche 1 bis 9,
**dadurch gekennzeichnet, daß**
der Testempfänger (BOST) aufweist:
- mindestens eine mit einem Testsignaleingang (A) des Testempfängers (BOST) verbundene Latchschaltung (2) zum Speichern der vom zu testenden Speicherbaustein empfangenen Datenantwort (DQ);
- eine in ihrer Verzögerungszeit (τ) programmierbare Verzögerungseinrichtung (3), die in einem Testzyklus das vom zu testenden Speicherbaustein empfangene Datenstrobe-Antwortsignal (DQS) verzögert und als internes verzögertes Strobesignal (DQS_{DEL}) einem Setzeingang der Latchschaltung (2) zum Einspeichern der anliegenden Datenantwort (DQ) zuführt.

11. Vorrichtung nach Anspruch 10,
**dadurch gekennzeichnet, daß**
der Testempfänger (BOST) weiterhin aufweist:
- eine Kalibriereinrichtung (4-12) zur Kalibrierung des Strobesignals (DQS_{DEL}) gegenüber der Datenantwort (DQ) vom zu testenden Speicherbaustein (DUT) in einem Kalibrierzyklus des Testempfängers (BOST), wobei die Kalibriereinrichtung mittels eines den Signaleingängen (A, B) des Testempfängers (BOST) zugeführten Taktsignals (8) und eines durch einen Vergleicher (6) ermittelten Latcherfolgs der Latchschaltung (2) für das der Latchschaltung (2) angelegte Kalibriersignal (DQ_{ML}) einen Wert zur Kalibrierung der Verzögerungszeit (τ) der Verzögerungseinrichtung (3) erzeugt.

12. Vorrichtung nach Anspruch 11,
**dadurch gekennzeichnet, daß**
die Kalibriereinrichtung (4-12) des Testempfängers (BOST) weiterhin aufweist:
- einen mit einem Programmiereingang der Verzögerungseinrichtung (3) verbundenen linearen Zähler (4) zum schrittweisen Verändern der Verzögerungszeit (τ) für die Verzögerungseinrichtung (3) im Kalibrierzyklus,
- eine Registereinheit (7), die, gesteuert vom Zähltakt des Zählers, im Kalibrierzyklus den jeweiligen vom Vergleicher (6) ermittelten Latcherfolg (oder Mißerfolg) der Latchschaltung (2) schrittweise über mehrere Zählerpositionen des Zählers (4) registriert, und
- eine Auswerteeinrichtung (12), die die von der Registereinheit (7) registrierten Werte hinsichtlich einer optimalen Verzögerungszeit (τ) für die Verzögerungseinrichtung (3) auswertet und den Zähler (4) für die Programmierung der Verzögerungszeit (τ) in der Verzögerungseinrichtung (3) entsprechend für den Testzyklus einstellt.

13. Vorrichtung nach einem der Ansprüche 10 bis 12,
**dadurch gekennzeichnet, daß**
die Datenantwort (DQ) vom zu testenden Speicherbaustein (DUT) einer Datenantwortsignalgruppe zugehörig ist und daß eine der Anzahl der Datenantwortsignale der Antwortsignalgruppe entsprechende Anzahl von Latchschaltungen (2) im Testempfänger (BOST) vorgesehen sind.

14. Vorrichtung nach einem der Ansprüche 10 bis 13,
**dadurch gekennzeichnet, daß**
für jedes Datenantwortsignal (DQ) zwei Latchschaltungen (2) jeweils für die Einspeicherung einer steigenden und fallenden Flanke der Datenantwort (DQ) vorgesehen sind.

15. Vorrichtung nach einem der Ansprüche 10 bis 14,
**dadurch gekennzeichnet, daß**
der Testempfänger (BOST) in einer von einem herkömmlichen Testequipment separaten Halbleiterschaltung (Build Outside Self Test) implementiert ist, die in unmittelbarer Nähe des jeweiligen zu testenden Speicherbausteins (DUT), insbesondere DRAM-Speichers, angeordnet ist.

## Claims

1. Method of reading and of checking the time position of a data response (DQ) read out from a fast memory module to be tested, in particular a DRAM memory in DDR operation, in a test receiver (BOST) during the test, **characterized in that** the reading of the data response (DQ) is controlled in terms of time by a strobe signal (DQS_{DEL}), which is generated in the test receiver (BOST) from a data strobe response signal (DQS) output by the memory module (DUT) to be tested and received by the test receiver (BOST), the time position of the data response (DQ) being checked by comparing it with the strobe signal (DQS_{DEL}) generated in the test receiver (BOST).

2. Method according to claim 1, **characterized in that** the strobe signal (DQS_{DEL}) is generated by means of a time delay by a specific delay time (τ) of the data strobe response signal (DQS) received in the test receiver (BOST), the delay time (τ) being determined and set in accordance with desired values of the time position of the data response (DQ) read from the memory module (DUT) to be tested and the data strobe response signal (DQS).

3. Method according to claim 2, **characterized in that** the set delay time (τ) is programmed into a programmable delay device (3) of the test receiver (BOST).

4. Method according to claim 2 or 3, **characterized in that** to determine the delay time (τ) (BOST), a calibration signal (DQ_{KAL}, DQS_{KAL}) for the data response (DQ) and the data strobe response signal (DQS) is generated in the test receiver and supplied to the test signal inputs (A, B) for the data response (DQ) and the data strobe response signal (DQS).

5. Method according to either of claims 2 and 3, **characterized in that** to determine the delay time (τ) to be programmed into the delay device (3), the test signal inputs (A, B) of the test receiver (BOST) for the data response (DQ) and the data strobe response signal (DQS) have an externally generated calibration signal (DQ_{KAL}, DQS_{KAL}) applied to them.

6. Method according to claim 4 or 5, **characterized in that** the calibration signals (DQ_{KAL}, DQS_{KAL}) for the data response (DQ) and the data strobe response signal (DQS) are identical clock signals.

7. Method according to claim 6, **characterized in that** the calibration signals (DQ_{KAL}, DQS_{KAL}) are generated as a symmetrical clock signal at a frequency that agrees with the frequency of the data response (DQ) and of the data strobe response signal (DQS) from the memory module (DUT) to be tested.

8. Method according to one of the preceding claims, **characterized in that** the data response (DQ) to be read from the memory module to be tested is a data response signal group, whose individual signals in each case have the same desired time relationship with the data strobe response signal (DQS) generated by the memory module to be tested.

9. Method according to one of the preceding claims, **characterized in that** the delay time (τ) determined and to be programmed into the delay device (3) is stored as a test comparison value for the time relationship between the data response (DQ) and the data strobe response signal (DQS), and is used to test this time relationship.

10. Device for reading and for checking the time position of a data response (DQ) read out from a memory module (DUT) to be tested, in particular from a DRAM memory in DDR operation, in a test receiver (BOST) during the test, in particular for implementing the method according to one of claims 1 to 9, **characterized in that** the test receiver (BOST) has:
- at least one latch circuit (2), connected to a test signal input (A) of the test receiver (BOST), to store the data response (DQ) received from the memory module to be tested;
- a delay device (3) whose delay time (τ) can be programmed and which, in a test cycle, delays the data strobe response signal (DQS) received from the memory module to be tested and supplies it, as an internal delayed strobe signal (DQS_{DEL}), to a set input of the latch circuit (2) in order to store the data response (DQ) that is present.

11. Device according to claim 10, **characterized in that** the test receiver (BOST) additionally has:
- a calibration device (4-12) for calibrating the strobe signal (DQS_{DEL}) with respect to the data response (DQ) from the memory module (DUT) to be tested in a calibration cycle of the test receiver (BOST), the calibration device generating a value for calibrating the delay time (τ) of the delay device (3) by means of a clock signal (8) supplied to the signal inputs (A, B) of the test receiver (BOST) and a latching success, determined by a comparator (6), of the latching circuit (2) for the calibration signal (DQ_{KAL}) applied to the latch circuit (2).

12. Device according to claim 11, **characterized in that** the calibration device (4-12) of the test receiver (BOST) additionally has:
- a linear counter (4), which is connected to a programming input of the delay device (3), for the stepwise changing of the delay time (τ) for the delay device (3) in the calibration cycle,
- a register unit (7) which, controlled by the counting cycle of the counter, during the calibration cycle registers the respective latching success (or failure) of the latching circuit (2), determined by the comparator (6), stepwise over a plurality of counter positions of the counter (4), and
- an evaluation device (12), which evaluates the values registered by the register unit (7) with regard to an optimum delay time (τ) for the delay device (3), and sets the counter (4) for programming the delay time (τ) in the delay device (3) appropriately for the test cycle.

13. Device according to one of claims 10 to 12, **characterized in that** the data response (DQ) from the memory module (DUT) to be tested belongs to a data response signal group, and **in that** a number of latch circuits (2) corresponding to the number of data response signals from the response signal group are provided in the test receiver (BOST).

14. Device according to one of claims 10 to 13, **characterized in that,** for each data response signal (DQ), two latch circuits (2) are provided, in each case to store a rising and falling edge of the data response (DQ).

15. Device according to one of claims 10 to 14, **characterized in that** the test receiver (BOST) is implemented in a semiconductor circuit (Build Outside Self Test) which is separate from conventional test equipment and is arranged in the immediate vicinity of the respective memory module (DUT) to be tested, in particular the DRAM memory.

## Revendications

1. Procédé de lecture et de contrôle de la position dans le temps d'une réponse (DQ) de données dans un récepteur (BOST) de test lue, lors du test, dans un module de mémoire rapide à tester, notamment d'une mémoire DRAM en fonctionnement DDR,
**caractérisé en ce que** l'on commande la lecture de la réponse (DQ) de données dans le temps par un signal (DQS_{DEL}) d'activation, qui est produit dans le récepteur (BOST) de test à partir d'un signal (DQS) de réponse d'activation de données émis par le module (DUT) de mémoire à tester et reçu par le récepteur (BOST) de test, le contrôle de la position dans le temps de la réponse (DQ) de données s'effectuant par sa comparaison avec le signal (DQS_{DEL}) d'activation produit dans le récepteur (BOST) de test.

2. Procédé suivant la revendication 1,
**caractérisé en ce que** l'on produit le signal (DQS_{DEL}) d'activation en retardant dans le temps, d'une durée (τ) de retard déterminée, le signal (DQS) d'activation de données reçu dans le récepteur (BOST) de test, la durée (τ) de retard étant déterminée et réglée en fonction de valeurs de consigne de la position dans le temps de la réponse (DQ) de données lue par le module (DUT) de mémoire à tester et du signal (DQS) de réponse d'activation de données.

3. Procédé suivant la revendication 2,
**caractérisé en ce que** l'on programme la durée (τ) de retard réglée dans un dispositif (3) de retard programmable du récepteur (BOST) de test.

4. Procédé suivant la revendication 2 ou 3,
**caractérisé en ce que,** pour la détermination de la durée (τ) (BOST) de retard, on produit dans le récepteur de test un signal (DQ_{KAL}. DQS_{KAL}) d'étalonnage pour la réponse (DQ) de données et pour le signal (DQS) de réponse d'activation de données et on l'envoie aux entrées (A, B) de signal de test pour la réponse (DQ) de données et pour le signal (DQS) de réponse de l'activation de données.

5. Procédé suivant la revendication 2 ou 3,
**caractérisé en ce que,** pour la détermination de la durée (τ) de retard à programmer dans le dispositif (3) de retard, on applique un signal (DQ_{KAL}, DQS_{KAL}) d'étalonnage, produit extérieurement, aux entrées (A, B) de signal de test du récepteur (BOST) de test pour la réponse (DQ) de données et pour le signal (DQS) de réponse d'activation de données.

6. Procédé suivant la revendication 4 ou 5,
**caractérisé en ce que** les signaux (DQ_{KAL}, DQS_{KAL}) d'étalonnage pour la réponse (DQ) de données et pour le signal (DQS) d'activation de données sont des signaux d'horloge identiques.

7. Procédé suivant la revendication 6,
**caractérisé en ce que** l'on produit les signaux (DQ_{KAL}, DQS_{KAL}) d'étalonnage sous la forme d'un signal d'horloge symétrique, ayant une fréquence coïncidant avec la fréquence de la réponse (DQ) de données et du signal (DQS) de réponse d'activation de données du module (DUT) de mémoire à tester.

8. Procédé suivant l'une des revendications précédentes,
**caractérisé en ce que** la réponse (DQ) de données à lire par le module de mémoire à tester est un groupe de signaux de réponse de données, dont les signaux individuels ont respectivement la même relation de consigne temporelle avec le signal (DQS) de réponse d'activation de données produit par le module de mémoire à tester.

9. Procédé suivant l'une des revendications précédentes,
**caractérisé en ce que** l'on mémorise la durée (τ) de retard, déterminée et à programmer dans le dispositif (3) de retard, sous la forme d'une valeur de comparaison de test pour la relation temporelle entre le mot (DQ) de données et le signal (DQS) de réponse d'activation de données et on utilise cette relation temporelle pour le test.

10. Dispositif de lecture et de contrôle de la position dans le temps d'une réponse (DQ) de données dans un récepteur (BOST) de test à lire, lors du test, dans un module (DUT) de mémoire à tester, notamment d'une mémoire DRAM en fonctionnement DDR, notamment pour la mise en oeuvre du procédé suivant l'une des revendications 1 à 9, **caractérisé en ce que** le récepteur (BOST) de test a :
- au moins un circuit (2) de verrouillage, relié à une entrée (A) de signal de test du récepteur (BOST) de test pour mémoriser la réponse (DQ) de données reçue par le module de mémoire à tester ;
- un dispositif (3) de retard, à durée (τ) de retard pouvant être programmée, qui retarde, dans un cycle de test, le signal (DQS) de réponse d'activation de données reçu par le module de mémoire à tester et l'envoie, en tant que signal (DQS_{DEL}) interne d'activation retardé, à une entrée de positionnement du circuit (2) de verrouillage pour mémoriser la réponse (DQ) de données appliquée.

11. Dispositif suivant la revendication 10,
**caractérisé en ce que** le récepteur (BOST) de test a, en outre :
- un dispositif (4-12) d'étalonnage, pour étalonner le signal (DQS_{DEL}) d'action par rapport à la réponse (DQ) de données du module (DUT) de mémoire à tester dans un cycle d'étalonnage du récepteur (BOST) de test, le dispositif d'étalonnage produisant une valeur d'étalonnage de la durée (τ) de retard du dispositif (3) de retard au moyen d'un signal (8) d'horloge envoyé à l'une des entrées (A, B) de signal du récepteur (BOST) de test et d'un succès, déterminé par un comparateur (6), du circuit (2) de verrouillage pour le signal (DQ_{KAL}) d'étalonnage appliqué au circuit (2) de verrouillage.

12. Dispositif suivant la revendication 11,
**caractérisé en ce que** le dispositif (4-12) d'étalonnage du récepteur (BOST) de test a, en outre :
- un compteur (4) linéaire relié à une entrée de programmation du dispositif (3) de retard, pour modifier pas à pas la durée (τ) de retard pour le dispositif (3) de retard dans le cycle d'étalonnage,
- une unité (7) de registre qui, commandée par la cadence de comptage du compteur, enregistre dans le cycle d'étalonnage le succès (ou l'échec) déterminé respectivement par le comparateur (6) du circuit (2) de verrouillage pas à pas sur plusieurs positions du compteur (4), et
- une unité (12) d'exploitation, qui exploite les valeurs enregistrées par l'unité (7) de registre en vue d'une durée (τ) de retard la meilleure possible pour le dispositif (10) de retard et règle conformément au cycle de test le compteur (4) pour la programmation de la durée (τ) de retard dans le dispositif (3) de retard.

13. Dispositif suivant l'une des revendications 10 à 12,
**caractérisé en ce que** la réponse (DQ) de données du module (DUT) de mémoire à tester fait partie d'un groupe de signaux de réponse de données et **en ce qu'**il est prévu, dans le récepteur (BOST) de test, un nombre de circuits (2) de verrouillage correspondant au nombre des signaux de réponse de données du groupe de signaux de réponse.

14. Dispositif suivant l'une des revendications 10 à 13,
**caractérisé en ce qu'**il est prévu, pour chaque signal (DQ) de réponse de données, deux circuits (2) de verrouillage, respectivement pour la mémorisation d'un front montant et descendant de la réponse (DQ) de données.

15. Dispositif suivant l'une des revendications 10 à 14,
**caractérisé en ce que** le récepteur (BOST) de test est mis en oeuvre dans un circuit à semi-conducteurs distinct de l'équipement de test habituel (Build Outside Self Test), qui est disposé à proximité immédiate du module (DUT) de mémoire respectif à tester, notamment de la mémoire DRAM.
